Europäisches Patentamt

European Patent Office

Office européen des brevets

(19)

(11) **EP 0 699 922 A2**

## (12) EUROPEAN PATENT APPLICATION

(43) Date of publication:
06.03.1996 Bulletin 1996/10

(51) Int. Cl.$^6$: **G01R 33/035**

(21) Application number: 95108601.6

(22) Date of filing: 06.06.1995

(84) Designated Contracting States:
DE FR GB

(30) Priority: 29.08.1994 US 297208

(71) Applicant: **International Business Machines Corporation**
**Armonk, N.Y. 10504 (US)**

(72) Inventors:
• **Gallagher, William Joseph**
  **Ardsley, New York 10502 (US)**

• **Koch, Roger Hilsen**
  **Amawalk, New York 10501 (US)**
• **Sun, Jonathan Zanhong**
  **Mohegan Lake, New York 10547 (US)**

(74) Representative: **Lindner-Vogt, Karin, Dipl.-Phys.**
**IBM Deutschland,**
**Informationssysteme GmbH,**
**Patentwesen und Urheberrecht**
**D-70548 Stuttgart (DE)**

(54) **Method to improve performance of a superconducting magnetometer in a magnetic field**

(57) The present invention significantly decreases the low frequency noise in the circuits (5) of superconducting quantum interference devices (SQUIDS) after exposure to applied magnetic fields while in the superconducting state by the inclusion of a weak link (25) in the superconducting flux sensing (pickup) loop (20) of the SQUID.

FIG. 2

## Description

The United States Government has rights in this invention pursuant to Contract No. N00014-92-C-0193.

### Background of the Invention

The present invention relates to weak links generally, specifically Josephson tunnel junctions, and more particularly to the use of such links to reduce low frequency noise in the circuits of superconducting quantum interference devices (SQUIDS) operated in magnetic fields.

A Josephson junction is formed by two superconducting electrodes separated by a thin oxide barrier layer. A zero-voltage supercurrent will flow between the electrodes due to the quantum mechanical tunnelling of electrons, in Cooper pairs, through the barrier layer. If a voltage is maintained across the junction between the electrodes, there will be an alternating current flow of frequency $f=2eV/h$, where e is the charge of the electron and h is Planck's constant.

The oxide layer of the Josephson junction is one type of weak connection between two superconductors that is part of a broader class of connections called weak links. Such weak links can also be comprised of, for example, a normal metal layer made weakly superconductive by the proximity effect, a short narrow physical constriction in an otherwise continuous superconducting loop, variable thickness bridges, damaged superconducting regions, grain boundaries, and a lower Tc superconducting layer. The maximum dc supercurrent that a weak link can carry is called the critical current, Ic. It is also the amplitude of the ac supercurrent that flows if a voltage is applied across the weak link. The critical current is a function of the temperature and the physical properties of the junction.

If a current greater than Ic is imposed across the junction, a voltage V will appear across the junction and the junction will act as a resistor to part of the current and will dissipate it while the Josephson current will persist.

The Josephson junction has found many practical applications. One large area of application for Josephson junctions has been in superconducting quantum interference devices (SQUIDS). Such devices, as discussed in the article by J. Clarke in Scientific American, vol. 271, No. 2, pp. 46-53 (August 1994), which article is herein incorporated by reference, are capable of measuring extremely small voltages, magnetic flux and changes in magnetic flux. A dc SQUID consists of a ring of superconducting material interrupted by two Josephson junctions. A bias current applied to the ring causes a supercurrent to flow across the junctions. If the current is greater than the critical current, a voltage will appear across the SQUID. Magnetic fields applied to the SQUID will cause changes in critical current and hence the voltage which can be measured and related back to the intensity of the field. Due to the quantum-mechanical phenomenon known as flux quantization, the flux contained within the superconducting SQUID ring cannot assume any value, rather it must be an integral number of a quantity called the flux quantum.

SQUIDS have found applications as voltmeters; magnetometers for measuring magnetic fields and time dependent changes in magnetic fields; gradiometers for measuring spacial differences in magnetic fields; and, as described in U. S. Patent 4,585,999 to Hilbert, et al., herein incorporated by reference, as the input amplifying element for a low noise, broad band radio frequency amplifier.

Another area of application is found in U. S. Patent 4,733,182, Clarke, et al., herein incorporated by reference, which discloses the use of Josephson tunnel junctions in an inductive-capacitive resonant electrical circuit in, for example, a system for the detection of pulsed magnetic resonance, to rapidly damp out oscillations caused by the pulse initially applied to the specimen being investigated.

Whenever a superconducting loop is placed in a magnetic field, the superconducting loop tries to screen, or null out, the magnetic field by producing a current flowing around the loop. As this current circulates around the loop, it tends to inject flux vortices of one flux quantum into the edges of the superconducting loop. Even after the magnetic field is removed, the injected flux vortices usually remain in the body of the loop. These flux vortices introduce noise in the loop due to thermally activated motion between different metastable trapping sites in the loop. Such noise will continue, oftentimes for long periods of time, until the vortices settle into relatively stable trapping sites. Present day SQUIDS are susceptible to low frequency noise due to the entrapment of magnetic flux vortices when operated in magnetic fields (typically the Earth's field).

### Summary of the Invention

The present invention significantly reduces the low frequency noise in the circuits of superconducting quantum interference devices (SQUIDS) after exposure to applied magnetic fields while in the superconducting state by the inclusion of a weak link in the superconducting flux sensing (pickup) loop of the SQUID.

### Brief Description of the Drawings

Other features and advantages of the present invention will be apparent from the following description taken in connection with the accompanying drawings, wherein:

FIG. 1 is a schematic plan view of the reference SQUID magnetometer;

FIG. 2 is a schematic plan view of a SQUID magnetometer having the invention therein;

FIG. 3 is a schematic plan view of a SQUID magnetometer using the invention in the field sensing loop connected to a multi-turn, multi-level input structure;

FIG. 4 is a graph of the power spectrum of the magnetic flux noise in the reference SQUID before and after the application of an applied field; and

FIG. 5 is a graph of the power spectrum of the magnetic flux noise in the SQUID having the invention therein before and after the application of an applied field; and

FIG. 6 is a graph of the power spectrum of the magnetic flux noise in a SQUID having the invention therein after cooling to 77°K; in a zero field and in an applied field of 0.5G immediately after and 20 minutes after field application.

Detailed Description of the Invention

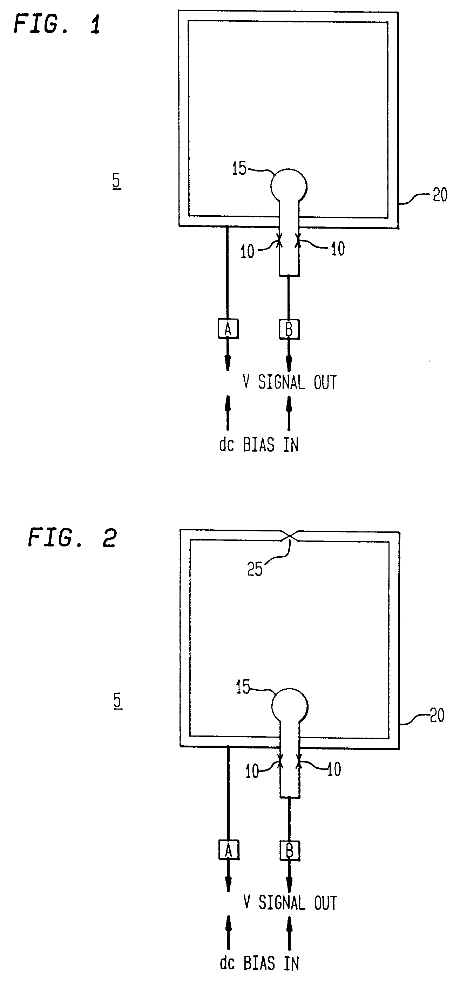

A SQUID magnetometer having the invention therein was fabricated and tested and compared to a similar device without the invention, herein the reference SQUID magnetometer. The reference SQUID magnetometer 5, was a single-level, thin-film $YBa_2Cu_3O_7$ high-Tc SQUID magnetometer lithographically patterned to form the structure shown schematically in FIG. 1. Step-edge defined junctions 10 formed the necessary junctions in SQUID loop 15. Pickup loop 20 measured 5.7 X 5.76 mm with a nominal linewidth of 0.44mm. As shown at 25 of FIG. 2, a 2um weak link was inserted into field sensing (pickup) loop 20 of the SQUID magnetometer of the invention which was otherwise the same as the refernce SQUID. The weak link in this case was of the narrow physical constriction type but need not be so. A classical Josephson junction or any other weak link structure will also function similarly. More than one weak link in the sensing loop may also prove efficacious.

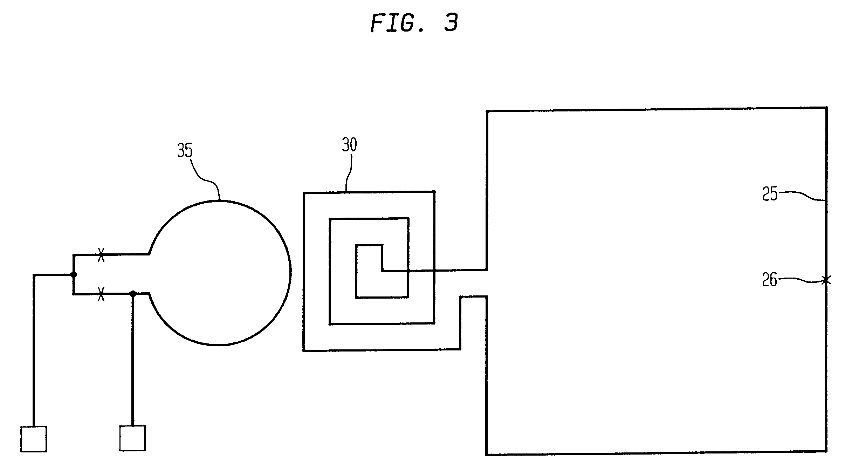

As shown in FIG. 1, pickup loop 20 is directly wired to SQUID loop 15. Alternatively, loop 20 could be inductively coupled to to loop 15 or could form a part of loop 15. Loop 20 could also be made in other geometries including the figure eight (or double loop of opposite sense) associated with SQUID gradiometers and susceptometers. FIG. 3 shows the use of the invention as weak link 26 in a single turn field (flux) sensing loop 25 connected to a multi-level, multi-turn input coil 30 inductively coupled to SQUID 35.

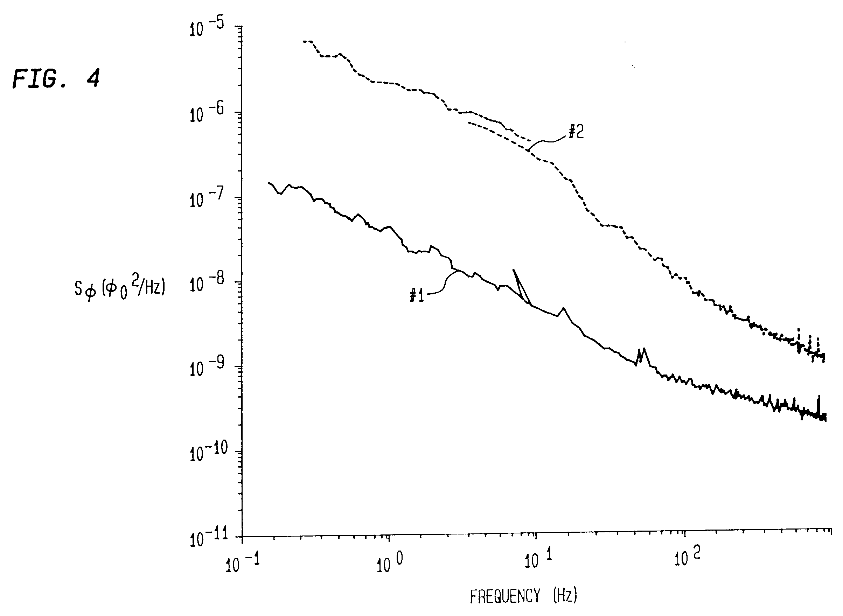

The noise spectrum for the reference SQUID, measured before and after exposure to a magnetic field, is shown in FIG. 4. The reference SQUID was cooled down to 77K in a nominally zero field (residual background field estimated to be less than 10mG). The noise spectrum of curve #1 of FIG. 4 was obtained. In FIG. 4, $S_\phi$ is the power spectrum of the magnetic flux noise. Noise spectra were again taken after the reference SQUID was exposed to a magnetic field of 1.0G with the field direction normal to the reference SQUID chip. This field is approximately twice the Earth's magnetic field. The reference SQUID was exposed to the field for two hours after which the field was turned off. After a waiting period of about 20 hours, the noise in the device had decayed to the level shown by curve #2 of FIG. 4. Even after the long 20 hour waiting period, such a field exposure caused a significant increase in the low frequency (1/f) noise in the reference SQUID.

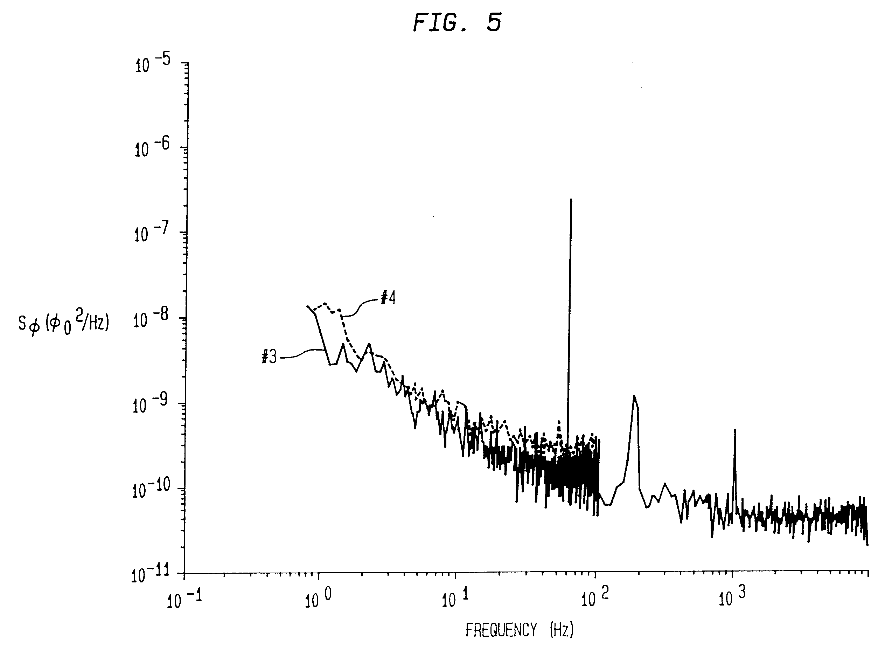

The experiment was repeated using the SQUID magnetometer containing the invention except the magnetic field exposure was to 0.5G for about one hour with a waiting period of only 3 hours compared to the 20 hour period for the reference SQUID magnetometer. The results are shown in FIG. 5. The solid curve (curve #3) is similar to curve #1 of FIG. 4 and is the noise spectrum after cooling to 77°K without the applied field. Curve #4 resulted after the field was applied for about an hour and then removed. It will be seen that in this case for the SQUID magnetometer having the device of the invention therein there is virtually no appreciable increase in the noise spectrum after exposure to the applied field in contrast to the reference SQUID magnetometer which did not contain the invention.

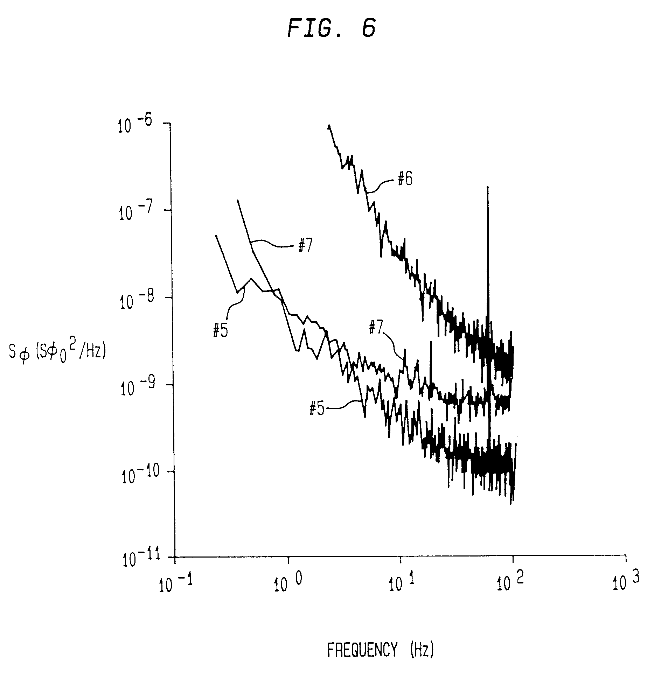

FIG. 6 shows the invention to be efficacious in the case where the SQUID device is operated in a field. In this case, the zero field noise spectrum of a SQUID magnetometer having the invention therein after cooling to 77°K is shown as curve #5 in FIG. 6. After that spectrum was obtained, a 0.5G field was applied and the noise spectrum of curve #6 was immediately taken. After 20 minutes in the applied field and at 77°K the noise, by virtue of the invention, had decayed to the low levels shown in curve #7 of FIG. 6.

It will be apparent to those of working skill in the art that modifications of this invention may be practiced without departing from the essential scope of this invention as defined by the appended claims.

**Claims**

1. The method of reducing the 1/f noise of a SQUID device comprising the insertion of at least one weak link into the flux sensing loop of the device.

2. The method of claim 1 wherein the weak link is a Josephson junction.

3. The method of claim 1 wherein the weak link is a constriction weak link.

4. A SQUID device having one or more weak links in its flux sensing loop.

5. The SQUID device of claim 4 wherein said weak link is a Josephson junction.

6. The SQUID device of claim 4 wherein said weak link is a constriction weak link.

FIG. 1

5

15

20

10      10

A      B

V SIGNAL OUT

dc BIAS IN

FIG. 2

25

5

15

20

10      10

A      B

V SIGNAL OUT

dc BIAS IN

EP 0 699 922 A2

# FIG. 3

35

30

25

26

FIG. 4

FIG. 5

EP 0 699 922 A2

# FIG. 6